# EUROPEAN PATENT APPLICATION

(11) **EP 3 876 287 A1**
(43) Date of publication of application: **08.09.2021**
(21) Application number: 20160471.7
(22) Date of filing: 02.03.2020
(51) Int. Cl.: H01L 29/06, H01L 29/423, H01L 29/775, H01L 27/088, H01L 27/092, B82Y 10/00, H01L 21/822, H01L 21/336

(54) **INNER SPACERS FOR NANOWIRES OR NANOSHEETS**

(71) Applicant: Imec VZW, 3001 Leuven (BE)
(72) Inventor: CHAN, Boon Teik, 3001 Leuven (BE); XIAO, Changyong, 3001 Leuven (BE); CHEN, Jie, 3001 Leuven (BE)
(74) Representative: DenK iP bv

(57) **Abstract**

A method (100) of forming an inner spacer (8a) between nanowires or nanosheets (2): forming (110) a fin (1) comprising a stack of the nanowires or nanosheets (2) alternated with sacrificial layers (3), with a dummy gate (4) on top of the stack; depositing (120) a sacrificial gate spacer (6); partially removing (130) the sacrificial gate spacer (6) such that a part of the fin (1) which is not below the dummy gate (4) is accessible; selectively removing (140) part of the sacrificial layers (3) using an etchant which undercuts into the sacrificial layer (3) underneath the sacrificial gate spacer (6), thereby forming cavities (7); removing (150) the sacrificial gate spacer (6), depositing (160) a gate spacer (8) over the fin and into the cavities (7); recessing (170) the fin (1) and gate spacer (8), wherein the gate spacer (8a) remaining in the cavities is forming the inner spacer (8a).

## Description

### Field of the invention

The invention relates to the field of nanowire or nanosheet semiconductor devices. More specifically it relates to a method for forming an inner spacer between nanowires or nanosheets for a semiconductor device.

### Background of the invention

The formation of stacked nanowires or nanosheets is an important step for decreasing the feature sizes of semiconductor devices.

One important issue which has to be tackled is to reduce the parasitic capacitance due to overlap between the gate and source-drain region of a nanowire or nanosheet transistor formed in the stack.

In order to minimize this parasitic capacitance, the formation of an inner spacer between the nanowires of nanosheets has to be an integral part of the nanowire/nanosheet integration scheme. Forming the inner spacer, however, may be process and/or material intensive. There is therefore a need for strategies for forming the inner spacer.

One strategy for forming inner spacers is disclosed in US10269929. The disclosed method includes providing a semiconductor structure comprising at least one fin. The at least one fin comprises a stack of layers of sacrificial material alternated with layers of nanowire material. The semiconductor structure also comprises a dummy gate which partly covers the stack of layers of the at least one fin. The method, moreover, includes removing at least the sacrificial material next to the dummy gate and oxidizing the sacrificial material and the nanowire material next to the dummy gate. This removal results, respectively, in a spacer oxide and in a nanowire oxide. Additionally, the method includes removing the nanowire oxide until at least a part of the spacer oxide is remaining, wherein the remaining spacer oxide is the inner spacer.

Besides this strategy there is still room for other strategies for integrating the formation of an inner spacer in the nanowire/nanosheet integration scheme.

### Summary of the invention

It is an object of embodiments of the present invention to provide a good method for forming an inner spacer between nanowires or nanosheets for a semiconductor device.

The above objective is accomplished by a method and device according to the present invention.

Embodiments of the present invention relate to a method of forming an inner spacer between nanowires or nanosheets for a semiconductor device. The method comprises:
- forming a fin comprising a stack of the nanowires or nanosheets alternated with sacrificial layers, with at least one dummy gate on top of the stack and a hardmask covering the dummy gate,
- depositing a sacrificial gate spacer over the dummy gate and fin,
- partially removing the sacrificial gate spacer such that a part of the fin which is not below the dummy gate is accessible for an etchant and such that the sacrificial gate spacer remains present over the dummy gate and over the fin below the dummy gate and extends over a predefined space over the fin,
- selectively removing part of the sacrificial layers using an etchant, wherein the etchant undercuts into the sacrificial layer underneath the sacrificial gate spacer, thereby forming cavities,
- removing the sacrificial gate spacer,
- depositing a gate spacer over the fin and into the cavities,
- recessing the fin and gate spacer next to the dummy gate, wherein the gate spacer remaining in the cavities is forming the inner spacer.

In embodiments of the present invention recessing the fin and gate spacer is done using one or more anisotropic etchants.

The anisotropic etchant is thereby etching in a direction orthogonal to the nanowires or nanosheets. One or more anisotropic etchants may be used. In case more than one anisotropic etchant is used the etchants may be applied sequentially. Depending on the material to be etched (e.g. material of nanowire or nanosheet, material of sacrificial layers, material of gate spacer) a different anisotropic etchant may be used.

In embodiments of the present invention the etchant used for selectively removing the sacrificial layers is an isotropic etchant.

In embodiments of the present invention the sacrificial layers are SiGe layers and the nanowires or nanosheets are Si nanowires or nanosheets.

In embodiments of the present invention the fin is formed such that a plurality of dummy gates are present on top of the stack wherein a minimum predefined distance is present between the dummy gates and wherein in the selectively removing step the sacrificial layers between the dummy gates are removed.

It is an advantage of embodiments of the present invention that compared to prior art fins, the distance between the dummy gates can be kept smaller.

In embodiments of the present invention the nanosheets have a width between 5 and 20 nm. In embodiments of the present invention this may be from 7 to 10 nm.

In embodiments of the present invention the nanowires have a diameter between 5 and 20 nm. In embodiments of the present invention this may be from 7 to 10 nm.

In embodiments of the present invention the sacrificial gate spacer is removed by wet etching or by dry (gas) etch.

A method according to embodiments of the present invention may comprise epitaxially growing a source at one end of nanowire or nanosheet and a drain at the opposite end wherein the ends of the nanowire or nanosheet which are obtained by recessing the fin.

A method according to embodiments of the present invention may comprise forming an nFET or pFET from a nanosheet or nanowire and the corresponding source and drain.

In embodiments of the present invention an nFET and pFET are formed such that they are stacked on top of each other.

It is an advantage of embodiments of the present invention that a CFET architecture can be obtained.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

FIG. 1 shows a schematic 3D-drawing of a typical gate all around semiconductor device.
FIG. 2 shows a SEM image of an alternating stack of Si And SiGe layers wherein the inner spacers are formed by oxidizing the SiGe layers.
FIG. 3 shows intermediate planar like test structures after a cavity etch, after a conformal SiO2 fill, and after epi growth.
FIG. 4 illustrates an intermediate stack obtained, when performing an exemplary method in accordance with embodiments of the present invention, after forming the fin on the substrate.
FIG. 5 illustrates an intermediate stack obtained, when performing an exemplary method in accordance with embodiments of the present invention, after partially removing the sacrificial gate spacer.
FIG. 6 illustrates an intermediate stack obtained, when performing an exemplary method in accordance with embodiments of the present invention, after selectively etching sacrificial material.
FIG. 7 illustrates an intermediate stack obtained, when performing an exemplary method in accordance with embodiments of the present invention, after removing the sacrificial gate spacer.
FIG. 8 illustrates an intermediate stack obtained, when performing an exemplary method in accordance with embodiments of the present invention, after depositing a new gate spacer.
FIG. 9 illustrates an intermediate stack obtained, when performing an exemplary method in accordance with embodiments of the present invention, after a gate spacer and fin recess step.
FIG. 10 illustrates an intermediate stack obtained, when performing an exemplary method in accordance with embodiments of the present invention, after an epi growth step.
FIG. 11 shows a flow chart of an exemplary method in accordance with embodiments of the present invention.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

Embodiments of the present invention relate to a method 100 of forming an inner spacer 8a between nanowires or nanosheets 2. Forming the inner spacers is important for reducing the parasitic capacitance of eventual semiconductor devices formed in a fin 1 which comprises a stack of nanowires or nanosheets 2 alternated with sacrificial layers 3.

The method 100 comprises forming 110 the fin 1 which comprises a stack of the nanowires or nanosheets 2 alternated with the sacrificial layers 3 and forming at least one dummy gate 4 on top of the stack and a hardmask (HM) 5 covering the dummy gate 4. An isolating layer may be present between the dummy gate and the stack.

A method according to embodiments of the present invention moreover comprises depositing 120 a sacrificial gate spacer 6 over the dummy gate 4 and fin 1.

In a next step the sacrificial gate spacer is partially removed 130 such that a part of the fin 1 which is not below the dummy gate 4 is accessible for an etchant and such that the sacrificial gate spacer 6 remains present over the dummy gate 4 and over the fin 1 below the dummy gate and extends over a predefined space, in the length direction of the fin at both sides of the dummy gate, over the fin 1.

In a next step part of the sacrificial layers 3 is selectively removed 140 using an etchant . When etching, cavities 7 are formed as the etchant undercuts into the sacrificial layer 3 underneath the sacrificial gate spacer 6. Etching may be done at both sides of the dummy gate. The etchant should be selected such that it is etching the sacrificial layers and such that it is not etching the nanowires or nanosheets.

In a next step the sacrificial gate spacer 6 is removed 150.

This step is followed by a step wherein a new gate spacer 8 is deposited 160 over the fin and into the cavities 7.

Next the fin 1 and gate spacer 8 are recessed 170 next to the dummy gate (4). The remaining gate spacer 8a in the cavities is the inner spacer 8a.

In embodiments of the present invention the dummy gate 4 can for example be made of poly-silicon or amorphous silicon. The sacrificial spacer 6 can for example be made of Silicon Nitride. The gate hardmask 5 can for example be made of silicon dioxide (SiO₂) and/or silicon carbide doped oxide (SiCO). The final spacer 8 can for example be made of silicon nitride (Si₃N₄) or silicon carbide doped oxide (SiCO). The sacrificial layer may for example be removed by applying H₃PO₄ for SiN or for example by dry (gas) removal of SiN without plasma. The invention is, however, not limited thereto and any suitable etchant, known by the person skilled in the art, may be used.

Methods according to embodiments of the present invention may be integrated in a process for forming semiconductor devices such as gate all around devices or even a complete CFET architecture (e.g. nFET stacked on top of pFET). It is an advantage of embodiments of the present invention that the inner spacer will thereby reduce the parasitic capacitance of the semiconductor devices.

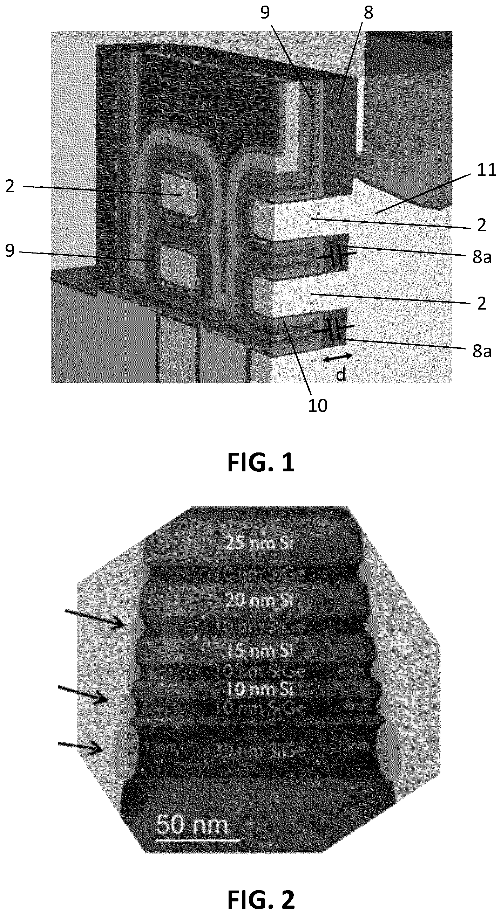

FIG. 1 shows a schematic 3D-drawing of a typical gate all around semiconductor device of which the front view shows a cross-section. The semiconductor device comprises nanowires 2, with a metal gate 9 around the nanowires, and an isolating layer 10 between the metal gate 9 and the nanowire 2. The isolating layer 10 may comprise high-k material such as for example HfO₂. The semiconductor device also comprises a spacer 8 on top of the nanowire stack and inner spacers 8a between the nanowires 2. The semiconductor device moreover comprises a Source/Drain 11.

Typically the inner spacer formation is integrated in the S/D module after the fin recess. This enables a constant gate length over the channel width for nanosheets.

First a fin may be formed which comprises an alternating stack of sacrificial layers and nanowire layers. The nanowire layers may for example be Si layers and the sacrificial layers may for example be SiGe layers. The Ge content in SiGe may for example be in the range between 20-30%. The higher the Ge% the higher the selectivity between SiGe versus Si during the nanowire release.

In prior art methods the inner spacers are for example formed by applying selective SiGe removal. This may be achieved by oxidation of SiGe. Several options may be considered for forming the inner spacer. The inner spacer may be formed from the side of the active region, or it may be formed from the gate side or it may be formed from the gate spacer side. Also, several moments in the integration scheme may be considered for forming the inner spacer. The inner spacer could for example be formed before the S/D epitaxial growth. Alternatively the inner spacer could be formed after release of the nanowire or nanosheet and after RMG gate trench.

It was noticed by the inventors that when forming the inner spacer with by oxidizing SiGe this will result in a variability of the SiGeOₓ inner spacer thickness for the inner spacers between the different nanowires. For such a method to be compatible with CFET device application the problem of a thicker SiGeOₓ at the N-P separation region needs to be solved. This problem is illustrated in FIG. 2. This figure shows the volume expansion of SiGeOₓ for SiGe layers with different thicknesses and illustrates that the oxidation width is SiGe thickness dependent. Another problem is that the SiGeOₓ may be removed by HF during the pre-clean for the EPI and the pre-clean for the replacement metal gate (RMG) process.

A method according to embodiments of the present invention comprises a cavity etch step and a fill step. Isotropic etching or anisotropic etching could be considered for the cavity etch step. Isotropic etching has the advantage that a minimum of process steps are required and that it is compatible with a SiN gate hardmask. It has, however, a small process window for nanoscale lateral etch control.

Anisotropic etching, on the other hand, has the advantage that it is independent on the lateral etch. It has, however, an increased process complexity and a thicker HM in the dummy gate is required. Because of the anisotropic etching recess is done on the STI and on the HM.

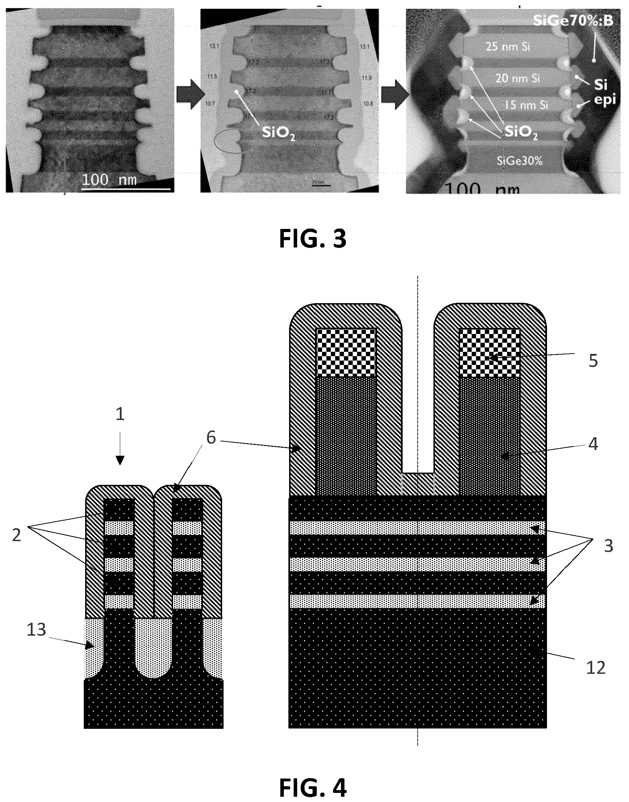

FIG. 3 shows intermediate planar like test structures after a cavity etch (left SEM image), after a conformal SiO2 fill (middle SEM image), and after the steps of SiO2 etchback, Si epi and SiGe:B S/D epi (right SEM image). Si nanowires with varying thicknesses are shown. The inner spacers are formed by a conformal SiO2 fill step. The cavity etch depends on the fin recess profile. As can be seen from this figure, a silicon nanowire narrowing or sharp silicon cornet can be observed, especially for the thinner silicon nanowires in the stack. This detrimental silicon corner is significant when targeting a silicon nanowire of 5-10 nm. This sharping will affect the EPI growth as is illustrated in the right SEM image of FIG. 3.

Isotropic etching increases the risk of process control for the spacer clearance on the tip of the horizontal Si NW. When performing isotropic etching the dielectric removal rate at the cavity is higher than the removal rate of the spacer. This implies the loss of inner spacer during isotropic etching.

Anisotropic etching has the risk of spacer clearance and of Si NW damage. Critical dimension control of the Si NW and gate spacer.

To overcome these problems, in a method according to embodiments of the present invention the sacrificial gate spacer 6 is deposited and etched, but the etching is done without doing the fin recess. This means that the fin is not chopped. The integrity of the nanowire or nanosheet is kept by not chopping it.

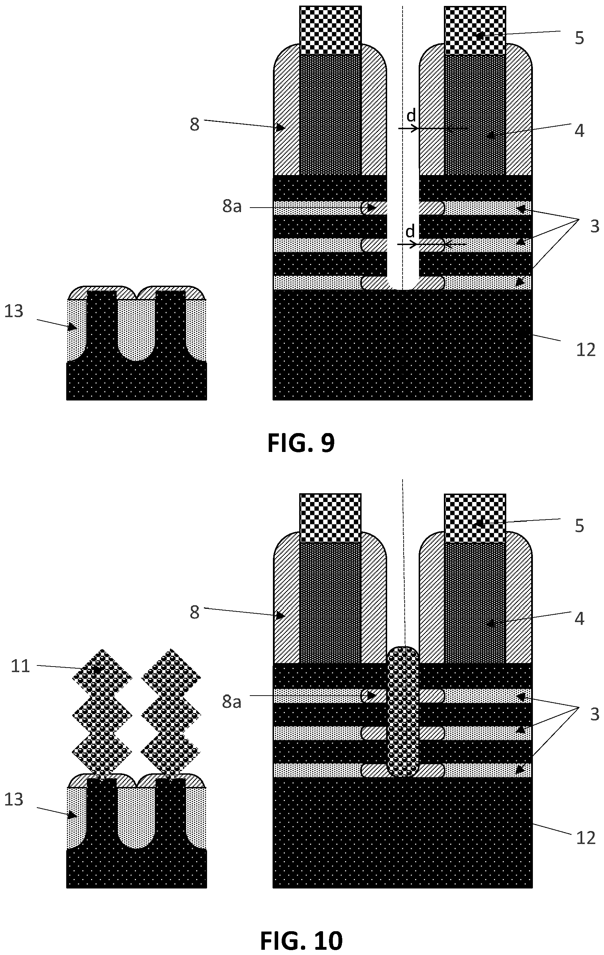

It is an advantage of embodiments of the present invention that an inner spacer can be formed which has a substantially constant thickness (d in FIG. 9) over the width of the sacrificial layer. It is, moreover, advantageous that the variability of the thickness between inner spacers can be reduced. Thus, a good control of the gate length can be achieved. In embodiments of the present invention the inner spacer is formed such that it has substantially the same thickness as the gate spacer.

It is an advantage of embodiments of the present invention that substantially the same gate length can be achieved over the complete width of the NW/NS.

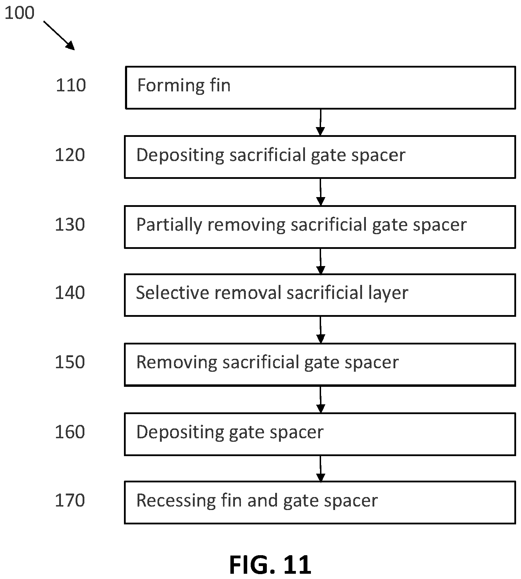

FIG. 11 shows a flow chart of an exemplary method in accordance with embodiments of the present invention. The method is illustrated by 2D schematic drawings of intermediate stacks in FIGs 4 to 10. For each intermediate stack a drawing parallel with the fin and a drawing orthogonal to the fin direction is shown.

The stack illustrated in FIG. 4 is obtained after forming 110 the fin 1 on the substrate 12, and after depositing 120 the sacrificial gate spacer 6. It shows the nanowires or nanosheets 2, the sacrificial layers 3, the dummy gates 4, the hardmasks 5, the sacrificial gate spacers 6, the substrate 12, and the STI oxide 13.

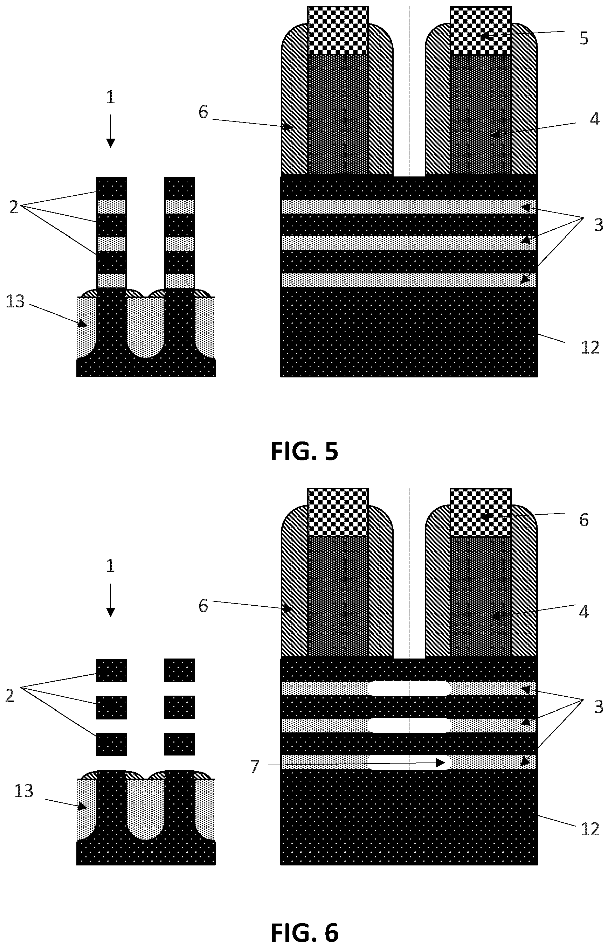

The stack, illustrated in FIG. 5, is obtained after partially removing 130 the sacrificial gate spacer. In this example the material of the sacrificial layers 3 is Silicon Germanium and the material of the nanowires or nanosheets 2 is Silicon.

This step is followed by selective removal step 140 wherein sacrificial material is etched selectively to the nanowire or nanosheet material such that an undercut 7 into the sacrificial layer underneath the gate spacer is obtained. In embodiments of the present invention this is achieved by isotropic etching. The stack obtained after this nanowire/nanosheet release step at the active region is illustrated in FIG. 6.

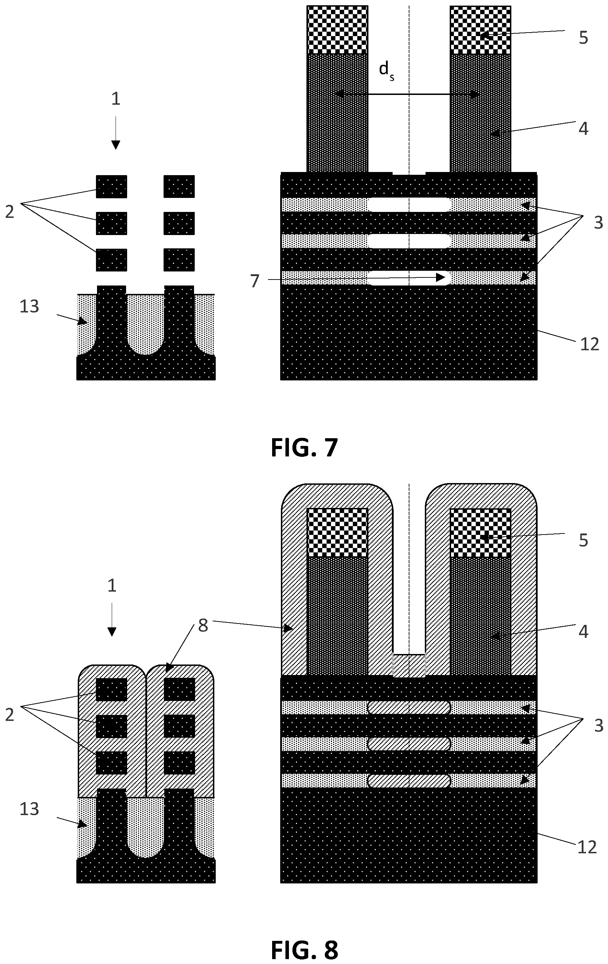

In a next step 150 the sacrificial gate spacer is removed. This may be achieved by wet etching or by isotropic dry (gas) etch. The resulting stack is shown in FIG. 7.

Next a new gate spacer 8 is deposited 160 over the fin 1 and into the cavities 7. This may for example be done through conformal coating. In embodiments of the present invention the gate spacer 8 is deposited such that it pinches off the cavity space 7 between the nanowires. The resulting stack is shown in FIG. 8.

This step is followed by a gate spacer and fin recess step 170 of which the resulting stack is shown in FIG. 9. In this step the new spacer 8 and the nanowire/nanosheet material are recessed down to the substrate without removing the gate spacer 8a from the cavities. In embodiments of the present invention this may be achieved by an anisotropic gate spacer and nanowire/nanosheet etch. The anisotropic etch should not go inside the cavities. Since this etching is directional with the newly deposited spacer 8 on the gate 4, no damage is done on the tips of the nanosheets or nanowires 2. It is an advantage of embodiments of the present invention that the etching can be directional because no undercutting is required since undercutting of the sacrificial layers was already done earlier in the process.

Etchants which may for example be used for the anisotropic etching are: CF₄ or a combination of CHₓF_{y} + SF₆ or an NF₃ chemistry in a single step. The invention is, however, not limited thereto and any suitable etchant, known by the person skilled in the art, may be used.

Multiple etch steps may be applied to etch the final spacer 8 (for example made of SiCO or Si₃N₄) and the nanowire/nanosheet material (for example Si) separately. HBr or Cl₂ chemistry could be used for Si and CHₓF_{y} chemistry could be used for dielectric.

The recessing step 170 may be followed by an epi-growth step 180 which may be preceded by an epi pre-clean step. A resulting stack is shown in FIG. 10. In the epi-growth step the source and drain 11 are formed. In embodiments of the present invention NMOS epi may be followed by PMOS epi or vice versa. Thereby the already grown epi needs to be protected when growing the other one. Thereafter the wafer may go through ILD0 followed by the RMG process.

Because of the directional removal there is no thinning of the nanowire or nanosheet is caused by the cavity etch. As no damage is done on the NW/NS surface a continuous NW/NS surface is obtained. This is advantageous for the S/D epi formation. Thus, a good S/D epi growth on a continuous NW/NS surface can be done.

It is an advantage of embodiments of the present invention that even for sacrificial layers with a small thickness good control of the NW/NS release process, especially the cavity etch process is possible. In embodiments of the present invention the cavity etch may be slower in comparison with the double sided nanowire release etch as the isotropic etch has access from both sides of the channel.

It is an advantage of embodiments of the present invention that the risk of the spacer 8 covering the NW/NS surface that could prevent epi growth is avoided, as the NW/NS 2 and spacer 8 are etched simultaneously.

It is an advantage of embodiments of the present invention that loss of the inner spacer during the directional NW or NS and gate spacer etch prior to epi growth is avoided. Because of the process steps directional etching is possible to obtain the stack on which epi-growth can be done.

In embodiments of the present invention the inner spacer can for example be a nitride (e.g. Si3N4 with k-value 7), an oxide (e.g. SiO2 with k-value 3), or an inner spacer with a low dielectric constant (e.g. k-value < 10, e.g. SiCO). The oxide is less preferable because it may at least partly be removed when exposing to HF in a next step.

It is an advantage of embodiments of the present invention that the uniformity, reliability and performance of a semiconductor device for which the spacer deposition is done using a method in accordance with embodiments of the present invention can be increased.

In embodiments of the present invention the thickness d of the inner spacer or the gate spacer is preferably in the range of 6 to 8 nm. Preferably the gate spacer and the inner spacer should be aligned and have the same thickness (see for example FIG. 1 and FIG. 9). In embodiments of the present invention the thickness of the sacrificial gate spacer 6 may be thicker or may be substantially the same as the thickness of the gate spacer 8.

In embodiments of the present invention a plurality of dummy gates 4 may be present on a fin 1. The distance dₛ (see FIG. 7), which is also referred to as the gate pitch or the contact poly pitch, may for example be 50 nm or less, or even 45 nm or less, or even 42 nm or less. When selectively removing part of the sacrificial layers, the sacrificial layers between the sacrificial gate spacers of neighboring dummy gates may be removed. Undercutting is done into the sacrificial layer underneath the sacrificial gate spacer.

## Claims

1. A method (100) of forming an inner spacer (8a) between nanowires or nanosheets (2) for a semiconductor device, the method (100) comprising:
- forming (110) a fin (1) comprising a stack of the nanowires or nanosheets (2) alternated with sacrificial layers (3), with at least one dummy gate (4) on top of the stack and a hardmask (5) covering the dummy gate,
- depositing (120) a sacrificial gate spacer (6) over the dummy gate (4) and fin (1),
- partially removing (130) the sacrificial gate spacer (6) such that a part of the fin (1) which is not below the dummy gate (4) is accessible for an etchant and such that the sacrificial gate spacer (6) remains present over the dummy gate (4) and over the fin (1) below the dummy gate and extends over a predefined space over the fin (1),
- selectively removing (140) part of the sacrificial layers (3) using an etchant, wherein the etchant undercuts into the sacrificial layer (3) underneath the sacrificial gate spacer (6), thereby forming cavities (7),
- removing (150) the sacrificial gate spacer (6),
- depositing (160) a gate spacer (8) over the fin and into the cavities (7),
- recessing (170) the fin (1) and gate spacer (8) next to the dummy gate (4), wherein the gate spacer (8a) remaining in the cavities is forming the inner spacer (8a).

2. A method (100) according to claim 1, wherein recessing (170) the fin (1) and gate spacer (8) is done using one or more anisotropic etchants.

3. A method (100) according to any of the previous claims, wherein the etchant used for selectively removing (140) the sacrificial layers (3) is an isotropic etchant.

4. A method (100) according to any of the previous claims, wherein the sacrificial layers are SiGe layers and wherein the nanowires or nanosheets are Si nanowires or nanosheets.

5. A method (100) according to any of the previous claims, wherein the fin (1) is formed such that a plurality of dummy gates (4) are present on top of the stack wherein a minimum predefined distance is present between the dummy gates (4) and wherein in the selectively removing step (140) the sacrificial layers between the dummy gates are removed.

6. A method (100) according to any of the previous claims, wherein the nanosheets have a width between 5 and 20 nm.

7. A method (100) according to any of the claims 1 to 5 wherein the nanowires have a diameter between 5 and 20 nm.

8. A method (100) according to any of the previous claims wherein the sacrificial gate spacer (6) is removed by wet etching.

9. A method (100) according to any of the previous claims, the method comprising epitaxially growing (180) a source at one end of nanowire or nanosheet and a drain at the opposite end wherein the ends of the nanowire or nanosheet which are obtained by recessing the fin (1).

10. A method (100) according to claim 9, the method comprising forming an nFET or pFET from a nanosheet or nanowire and the corresponding source and drain.

11. A method (100) according to claim 10, wherein an nFET and pFET are formed such that they are stacked on top of each other.
